# FASCICULE DE BREVET EUROPEEN

(11) **EP 1 337 683 B1**
(45) Date de publication et mention de la délivrance du brevet: **05.10.2011**
(21) Numéro de dépôt: 01974439.0
(22) Date de dépôt: 05.10.2001
(51) Int. Cl.: C23C 16/02, C30B 25/02, C30B 23/02

(54) **PROCEDE D'AUTO-ORGANISATION DE MICROSTRUCTURES OU DE NANOSTRUCTURES ET DISPOSITIF ASSOCIE OBTENU**
VERFAHREN ZUR SELBSTORGANISATION VON MIKRO- ODER NANOSTRUKUREN UND DAZUGEHÖRIGE VORRICHTUNG
METHOD FOR AUTOMATIC ORGANISATION OF MICROSTRUCTURES OR NANOSTRUCTURES AND RELATED DEVICE OBTAINED

(30) Priorité: 06.10.2000 FR 0012797
(43) Date de publication de la demande: 27.08.2003
(73) Titulaire: Commissariat à l'Énergie Atomique et aux Énergies Alternatives, 75015 Paris (FR); CENTRE NATIONAL DE LA RECHERCHE SCIENTIFIQUE (CNRS), 75794 Paris Cedex 16 (FR)
(72) Inventeur: SEMERIA, Marie-Noëlle, F-38250 SAINT-NIZIER-DU-MOUCHEROTTE (FR); MUR, Pierre, F-38920 CROLLES (FR); FOURNEL, Franck, F-38530 Moirans (FR); MORICEAU, Hubert, F-38120 SAINT-EGREVE (FR); EYMERY, Joël, F-38360 SASSENAGE (FR); MAGNEA, Nol, F-38430 MOIRANS (FR); BARON, Thierry, F-38600 FONTAINE (FR); MARTIN, François, F-38000 GRENOBLE (FR)
(74) Mandataire: Poulin, Gérard
(86) Numéro de dépôt international: PCT/FR2001/003073
(87) Numéro de publication internationale: WO 2002/029131

(56) Documents cités:
- EP-A- 0 598 361
- FR-A- 2 766 620
- ENOMOTO Y: "Dynamics of surface phase separation on patterned substrates by molecular beam epitaxy" THIN SOLID FILMS,ELSEVIER-SEQUOIA S.A. LAUSANNE,CH, vol. 369, no. 1-2, juillet 2000 (2000-07), pages 21-24, XP004200316 ISSN: 0040-6090
- HAUSLER K ET AL: "Ordering of nanoscale InP islands on strain-modulated InGaP buffer layers" SOLID STATE ELECTRONICS,GB,ELSEVIER SCIENCE PUBLISHERS, BARKING, vol. 40, no. 1, 1996, pages 803-806, XP004017899 ISSN: 0038-1101
- MUKHAMETZHANOV I ET AL: "INDEPENDENT MANIPULATION OF DENSITY AND SIZE OF STRESS-DRIVEN SELF-ASSEMBLED QUANTUM DOTS" APPLIED PHYSICS LETTERS,US,AMERICAN INSTITUTE OF PHYSICS. NEW YORK, vol. 73, no. 13, 28 septembre 1998 (1998-09-28), pages 1841-1843, XP000784174 ISSN: 0003-6951

## Description

### Domaine technique

L'invention concerne un procédé d'auto-organisation de microstructures ou de nanostructures en réseau bidimensionnel ou tridimensionnel. Elle concerne également un dispositif présentant des microstructures ou des nanostructures auto-organisées.

Ces microstructures ou nanostructures sont destinées à la réalisation de dispositifs électroniques, optiques, opto-électroniques ou magnétiques, en particulier des dispositifs à blocage de Coulomb mettant en oeuvre des boîtes quantiques.

### Etat de la technique antérieure

Il est connu que l'on peut déterminer un arrangement de microstructures ou de nanostructures sur une surface par les méthodes classiques de la photolithogravure. On dépose par exemple sur une surface une couche continue du matériau choisi comme constituant des microstructures ou des nanostructures. Il peut s'agir d'une couche de silicium déposée par LPCVD. Cette couche est recouverte d'un film photosensible. Après exposition de ce film, on relève les géométries, puis on les transfère dans le matériau sous-jacent. L'état de l'art actuel permet de définir ainsi des nanostructures de l'ordre de 20 nm. Cette taille est trop grande pour les applications visées par l'invention.

De nouvelles méthodes, appelées "nano-printing" permettent de définir des structures nanométriques par déformation d'un polymère avec moule par exemple. Dans ce cas aussi, l'ordre de grandeur des structures ainsi définies est difficilement inférieur à 20 nm.

On connaît aussi des techniques d'auto-organisation de matière permettant de faire croître des nanostructures : croissance sur le bord des marches d'une surface vicinale, auto-organisation par des réseaux de dislocation obtenus lors de la croissance de métaux, auto-organisation par des dislocations lors de la croissance de différentes couches semi-conductrices. On peut également faire de l'auto-organisation par des empilements de nanostructures ou par la croissance de nanostructures sur des surfaces contraintes qui présentent une variation de leur topologie à cause de la relaxation de la contrainte interne. On peut également se servir d'impuretés sur la surface d'épitaxie. Aucune de ces techniques ne semble permettre la faisabilité d'une auto-organisation de nanostructures de taille nanométrique avec une bonne homogénéité en taille.

Il est connu par ailleurs que l'on peut obtenir une organisation de nanostructures cristallines à partir d'un substrat cristallin à la surface duquel a été généré un champ de contrainte. Les nanostructures peuvent être obtenues par traitement sélectif du substrat et dans ce cas le matériau constitutif des nanostructures est le même que celui du substrat. Elles peuvent aussi être obtenues par croissance par épitaxie et dans ce cas le substrat cristallin et les nanostructures cristallines sont composées de matériaux qui diffèrent par leurs paramètres de maille.

Le document FR-A-2 766 620 divulgue un procédé de réalisation de microstructures ou de nanostructures sur un support. Le procédé comporte une étape de mise en contact de deux plaquettes de matériau cristallin de façon que les réseaux cristallins présentés par les faces des plaquettes mises en contact soient décalés d'un angle permettant la formation d'un réseau de défauts cristallins au sein d'une zone cristalline au voisinage de l'interface des deux plaquettes. Une étape postérieure d'amincissement de l'une des deux plaquettes permet de révéler la microstructure ou la nanostructure sur un support constitué par l'autre plaquette. La plaquette non amincie peut être un substrat SOI dont le film superficiel de silicium est mis en contact avec la plaquette amincie.

Plusieurs problèmes sont inhérents à ces procédés connus.

Un premier problème résulte du fait que les nanostructures sont en contact direct avec le substrat support, même si l'espace entre les nanostructures peut être rendu de nature différente, notamment de nature électrique différente, après des traitements appropriés, par exemple thermiques. Cependant, il peut être intéressant d'éviter les fuites de courant entre les nanostructures et le substrat support. En effet, de telles fuites sont rédhibitoires pour le contrôle du transport de l'électron d'une nanostructure à une autre.

Un deuxième problème résulte du fait que les procédés de l'art antérieur impliquent la génération d'un champ de contrainte dans le substrat, ce qui limite le choix du matériau constitutif des nanostructures. En effet, les paramètres de maille du substrat et des nanostructures doivent être compatibles avec la formation des nanostructures quand on dépose le deuxième matériau sur le substrat. Il n'est pas possible de déposer des nanostructures de même nature que le substrat. Il serait très intéressant par exemple de réaliser des nanostructures en silicium sur des substrats en silicium, ce matériau étant bien connu et largement exploité dans le domaine de la microélectronique.

Un troisième problème concerne l'optimisation des dispositifs à nanostructures.

### Exposé de l'invention

L'invention propose une solution aux problèmes exposés ci-dessus. Elle concerne un procédé d'auto-organisation de microstructures ou de nanostructures en réseau bidimensionnel ou tridimensionnel sur une couche intermédiaire qui peut avantageusement être de nature différente de celle du substrat. Cette couche intermédiaire est choisie de façon à ne pas gêner l'organisation des nanostructures sur le substrat. Cet arrangement est corrélé à un champ de contrainte créé à la surface du substrat et transmis par la couche intermédiaire jusqu'à sa surface. Cet arrangement de microstructures ou de nanostructures sur la surface de la couche intermédiaire peut à son tour être exploité pour organiser un ou plusieurs dépôts ultérieurs de microstructures ou de nanostructures.

L'invention permet de choisir indépendamment le substrat et le matériau constitutif des nanostructures.

Le substrat est cristallin, mono-matériau ou composite. La couche intermédiaire peut être cristalline ou amorphe.

Les nanostructures obtenues selon l'invention se présentent sous la forme d'un réseau de volumes de dimensions allant typiquement de un à quelque nanomètres. Ces nanostructures peuvent être en matériau conducteur, semi-conducteur ou diélectrique, de structure cristalline ou amorphe. On peut citer, à titre d'exemple, les composés IV-IV dont Si, Ge, C, les composés II-VI, les composés III-V, Al₂O₃, SiO₂ et Si₃N₄, les matériaux magnétiques dont Co, Ni, CoNi et les matériaux demi ou semi-métaux dont Bi et NiMnSb.

L'invention permet le dépôt de nanostructures auto-organisées de façon économique car le dépôt se fait en une seule fois sur toute une surface. Les dimensions des nanostructures vont de 1 nm à quelques dizaines de nm.

La couche intermédiaire de l'invention permet d'éviter toute contamination des nanostructures par le substrat. Elle a pour fonction d'une part de faciliter la mise en ordre des nanostructures sur le substrat et d'autre part d'isoler les nanostructures du substrat.

L'invention a donc pour objet un procédé de réalisation de microstructures ou de nanostructures sur un support, comprenant les étapes suivantes :
a) fourniture d'un substrat comprenant au moins une partie en matériau cristallin, cette partie possédant une surface présentant un champ de contrainte ou une topologie associée à un champ de contrainte, la surface étant adaptée à la formation d'une couche de matériau dite couche intermédiaire, par mise en contact de deux plaquettes de matériau cristallin de façon que les réseaux cristallins présentés par les faces des plaquettes mises en contact soient décalés d'un angle permettant la formation d'un réseau de défauts cristallins au sein d'une zone cristalline au voisinage de l'interface des deux plaquettes, l'une des plaquettes étant ensuite amincie jusqu'à révéler ladite surface présentant un champ de contrainte ou une topologie associée à un champ ce contrainte, le champ de contrainte étant alors associé à des dislocations dudit réseau de défauts cristallins,
b) formation de la couche intermédiaire à partir de ladite surface,
c) dépôt auto-organisé des microstructures ou des nanostructures sur la face libre de la couche intermédiaire,
caractérisé en ce que, à l'étape b), l'épaisseur et/ou la composition et/ou l'état de surface de la couche intermédiaire, sont choisis pour que le champ de contrainte puisse se transmettre à travers cette couche jusqu'à sa face libre qui est apte à la réalisation de microstructures ou de nanostructures, le substrat et la couche intermédiaire constituant ledit support.

L'étape a) peut aussi comprendre un traitement de surface pour adapter ladite surface à la formation d'une couche intermédiaire.

La couche intermédiaire peut être une couche déposée sur ladite surface par une technique PVD et/ou une technique CVD. Elle peut aussi être obtenue par le dépôt préliminaire d'un matériau sur ladite surface, ce dépôt préliminaire étant suivi d'un traitement permettant d'obtenir la composition choisie pour la couche intermédiaire. Elle peut aussi être obtenue par un traitement transformant une couche du substrat sous-jacente à ladite surface en la composition choisie pour la couche intermédiaire. Elle peut aussi être obtenue en faisant réagir une couche du substrat sous-jacente à ladite surface avec un matériau déposé sur ladite surface pour obtenir ladite composition choisie.

La couche intermédiaire peut être constituée d'un empilement de sous-couches. Selon une première variante, les sous-couches sont constituées d'un même matériau mais présentent des rugosités différentes. Selon une deuxième variante, les sous-couches sont constituées de différents matériaux, par exemple SiO₂ et Si₃N₄. Selon encore une autre variante, l'empilement de sous-couches comprend des sous-couches présentant des valeurs de contrainte de signes opposés. Ceci permet d'obtenir un effet d'amplification dans les sous-couches constituant la couche intermédiaire.

La couche intermédiaire peut être formée pour présenter un état de contrainte favorisant le dépôt auto-organisé des microstructures ou des nanostructures. Pour cela, elle peut être formée de façon à présenter une différence de coefficient de dilatation thermique avec le substrat telle que la couche intermédiaire présente ledit état de contrainte. Elle peut aussi être formée en faisant varier ses paramètres de croissance de façon à présenter ledit état de contrainte. Elle peut aussi être formée de façon à présenter une différence de paramètre de maille avec le substrat telle que la couche intermédiaire présente ledit état de contrainte.

Le dépôt auto-organisé des microstructures ou des nanostructures peut être réalisé par une technique choisie parmi le dépôt PVD, le dépôt CVD, le dépôt LPCVD, l'épitaxie liquide, le trempage, l'épitaxie gazeuse et le dépôt plasma.

L'étape de dépôt auto-organisé peut comporter une superposition de dépôts, un premier dépôt étant effectué sur la face libre de la couche intermédiaire et au moins un deuxième dépôt étant effectué ensuite pour obtenir une organisation tridimensionnelle des microstructure ou des nanostructures.

La face libre de la couche intermédiaire peut être traitée pour lui conférer un relief tel que les microstructure ou les nanostructures sont déposées selon une organisation tridimensionnelle. Ce relief peut être un profil en dents de scie.

L'invention a aussi pour objet un dispositif constitué de microstructures ou de nanostructures sur un support, comprenant :
- un substrat comprenant au moins une partie en matériau cristallin, cette partie possédant une surface présentant un champ de contrainte ou une typologie associée à un champ de contrainte, le substrat étant constitué d'une plaquette de matériau cristallin adhérant à un film mince de matériau cristallin selon des faces de contact, les réseaux cristallins présentés par les faces en contact étant décalés d'un angle permettant la formation d'un réseau de défauts cristallins au sein d'une zone cristalline au voisinage de l'interface entre la plaquette et le film mince, le champ de contrainte.étant alors associé à des dislocations dudit réseau de défauts cirstallins,
- une couche intermédiaire solidaire de ladite surface,
caractérisé en ce que la couche intermédiaire possède une épaisseur et/ou une composition et/ou un état de surface permettant la transmission dudit champ de contrainte à travers cette couche jusqu'à sa face libre qui supporte les microstructures ou les nanostructures.

La couche intermédiaire peut être constituée d'un empilement de sous-couches. Elle peut être une couche présentant un état de contrainte favorisant le dépôt auto-organisé des microstructures ou des nanostructures. Elle peut par exemple présenter une différence de coefficient de dilatation thermique avec le substrat telle que la couche intermédiaire présente ledit état de contrainte.

Les microstructures ou les nanostructures peuvent être disposées selon des couches superposées, formant ainsi une organisation tridimensionnelle.

La couche intermédiaire peut posséder une face libre présentant un relief tel que les microstructures ou les nanostructures forment une organisation tridimensionnelle.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue en coupe transversale d'un substrat en matériau cristallin et possédant une surface présentant un champ de contrainte, ce substrat permettant la réalisation d'un support de nanostructures selon l'invention,
- la figure 2 est une vue en coupe transversale d'un support de nanostructures selon l'invention,
- la figure 3 est une vue en coupe transversale d'un autre support de nanostructures selon l'invention,
- la figure 4 est une vue en coupe transversale d'un dispositif constitué de nanostructures sur un support selon l'invention,
- la figure 5 représente un dispositif utilisant des nanostructures sur un support selon l'invention.

### Description détaillée de modes de réalisation de l'invention

La partie qui suit de la description va porter sur la réalisation de nanostructures sur un support.

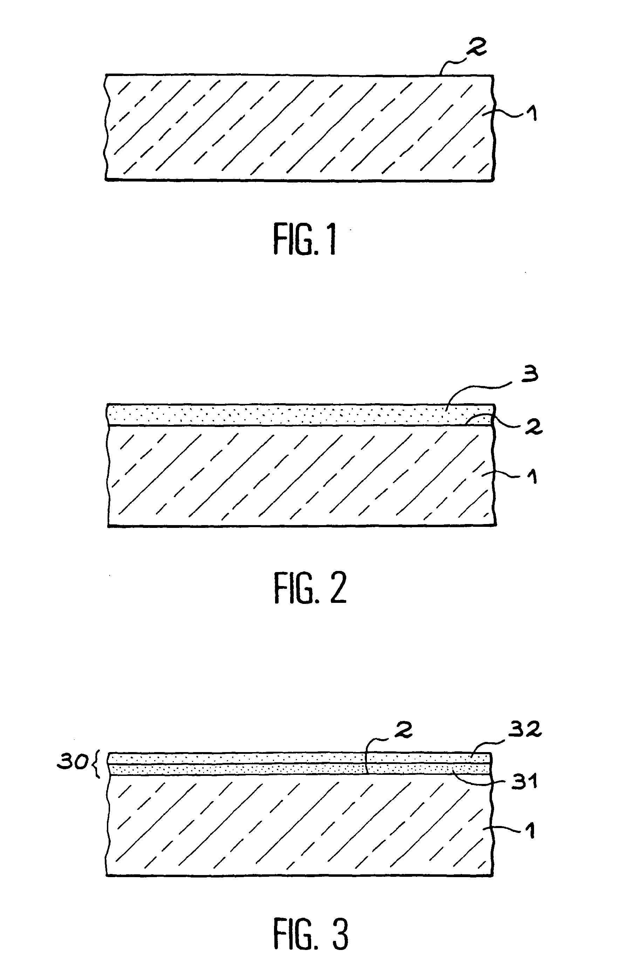

Le dispositif selon l'invention comprend un support constitué d'un substrat et d'une couche de matériau dite couche intermédiaire sur laquelle sont déposées les nanostructures. Le substrat est par exemple du type décrit dans le document FR-A-2 766 620. La figure 1 montre un tel substrat, référencé 1, possédant une surface 2 présentant un champ de contrainte.

La surface 2 du substrat 1 est traitée pour que la couche intermédiaire qui y sera formée soit couvrante, uniforme et homogène. Pour un substrat en silicium, ce traitement peut être basé sur une chimie à base d'HCl dilué incluant de l'ozone selon une technique connue en microélectronique.

La figure 2 montre le substrat 1 de la figure 1 supportant une couche intermédiaire 3 formée à partir de la surface traitée 2. La couche intermédiaire 3 peut être déposée sur la surface 2 par une technique PVD ou une technique CVD ou une combinaison de ces techniques. Si le substrat 1 est en silicium, la couche intermédiaire 3 peut être en SiO₂, en Si₃N₄, en oxynitrure. Elle peut être en matériau diélectrique, en matériau conducteur thermique (par exemple le diamant) ou électrique (par exemple Cu ou Al). Il peut s'agir d'un semi-métal (bismuth, Fe₃O₄, NiMnSb, CrO₂.) ou d'un matériau de filtrage optique.

Une variante de formation d'une couche intermédiaire consiste à déposer un matériau sur le substrat et d'en modifier la nature par un apport énergétique. On peut par exemple déposer de l'aluminium sur du silicium puis effectuer un recuit sous atmosphère oxydante de façon à obtenir une couche intermédiaire en Al₂O₃.

La couche intermédiaire est alors constituée en changeant la nature d'une partie du substrat, par consommation du matériau du substrat au moyen d'un traitement de surface approprié. Ce traitement peut consister en un recuit sous atmosphère contrôlée (O₂, H₂, N₂, Ar.) de type RTO (pour "Rapid Thermal Oxidation") ou au four. Le traitement peut aussi consister en une implantation ionique suivie d'un recuit. La surface du substrat peut aussi être soumise à un plasma ou une irradiation laser.

Dans le cas particulier d'un substrat de silicium dont la surface a été traitée pour l'adapter à la formation d'une couche intermédiaire, comme indiqué plus haut, et où une couche d'oxyde est formée par RTO, on peut avantageusement choisir une dilution en oxygène inférieure à 10%, une température de l'ordre de 800°C et une durée de recuit de quelques minutes.

La couche intermédiaire peut aussi être obtenue en faisant réagir la couche du substrat sous-jacente à la surface 2 avec un matériau déposé sur cette surface. La réaction s'obtient par exemple sous l'effet d'un apport d'énergie. Ainsi, dans le cas d'un substrat en silicium, une couche de platine ou de titane forme un siliciure après recuit.

Des combinaisons de ces techniques de formation de couche peuvent être employées pour former la couche intermédiaire.

L'épaisseur et/ou la composition de la couche intermédiaire et/ou son état de surface sont choisis de façon que le champ de contrainte du substrat se transmette à travers la couche intermédiaire et jusqu'à sa surface qui devient apte à la réalisation bien contrôlée des nanostructures.

Avantageusement, l'épaisseur de la couche intermédiaire est choisie de l'ordre du nanomètre. Ceci procure une meilleure efficacité de la déformation et/ou de tout ou partie de la topologie de surface liée au champ de contrainte.

La couche intermédiaire peut être en matériau diélectrique afin de mieux maîtriser les propriétés de transport des électrons dans les nanostructures.

Suivant l'application visée, la couche intermédiaire peut être constituée d'un empilement de sous-couches afin d'assurer la compatibilité avec le substrat d'une part et les nanostructures d'autre part. La figure 3 montre, à titre d'exemple, un substrat 1 en silicium dont la surface 2 supporte une couche intermédiaire 30 constituée d'une sous-couche 31 en SiO₂, déposée directement sur la surface 2, et d'une sous-couche 32 en Al₂O₃ destinée au dépôt des nanostructures.

La couche intermédiaire peut aussi servir à contrôler la diffusion d'éléments entre le substrat et les nanostructures. Par exemple, des éléments contaminants tels que l'aluminium peuvent diffuser dans la couche intermédiaire jusqu'à la surface libre dans le réseau et favoriser la croissance des nanostructures à leur endroit. La couche intermédiaire peut aussi avoir un rôle de barrière aux éléments contaminants présents dans une zone proche de la surface sur laquelle est déposée la couche intermédiaire.

La couche intermédiaire peut aussi présenter un état de contrainte apte à la réalisation de l'auto-organisation souhaitée des nanostructures. Cette contrainte peut être due à la différence des coefficients de dilatation thermique entre une couche intermédiaire unique et le substrat, ou entre les différentes sous-couches d'une couche intermédiaire et le substrat.

Cette contrainte peut aussi être due à la variation des paramètres de croissance de la couche intermédiaire (température de dépôt, épaisseur, mode de croissance). On peut ainsi obtenir le dépôt d'une couche de nitrure qui se trouve être en tension ou en compression avec des contraintes de l'ordre de quelques dizaines de MPa. Dans le cas d'une couche intermédiaire composée de sous-couches, la variation des paramètres de croissance des différentes sous-couches (épaisseur, température de dépôt, mode de croissance) permet de contrôler la valeur de contrainte imposée.

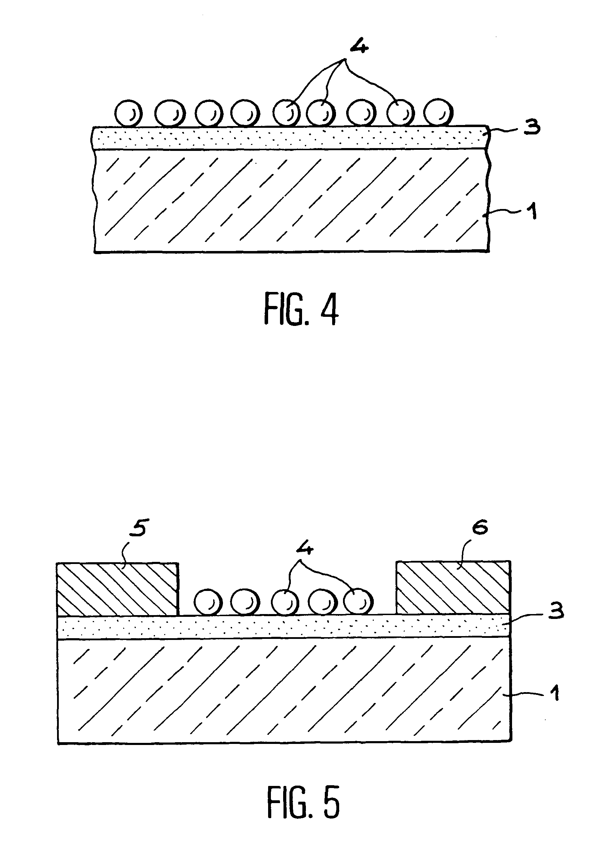

La figure 4 montre des nanostructures 4 déposées sur un support comprenant un substrat 1 et une couche intermédiaire 3, comme celui représenté à la figure 2. Les conditions opératoires sont ajustées de façon à former des îlots de 1 à quelques dizaines de nanomètres, avec le moins de dispersion possible (par exemple moins de 10 %) et avec une densité suffisante pour l'application visée. La densité peut être de 10¹² ilots/cm² pour le transport d'électrons d'une nanostructure à une autre.

Cette étape de dépôt des nanostructures peut être complétée par une étape ultérieure : traitement thermique sous atmosphère contrôlée, autre dépôt (par exemple d'un diélectrique fin) de façon à fixer les états d'interface ou pour affiner les propriétés de la nanostructure ou encore pour obtenir un réarrangement ou modifier la dispersion en taille des nanostructures.

Une étape ultérieure permet d'ajouter aux nanostructures des éléments tels que l'erbium, ce qui permet d'augmenter les propriétés de photoluminescence.

On peut également tirer avantage de l'organisation bidimensionnelle ou tridimensionnelle d'un premier dépôt de nanostructures pour empiler un ou plusieurs autres dépôts de nanostructures en alternance ou pas avec un autre dépôt de façon à faire varier ou non la densité des nanostructures et par conséquent modifier leur rendement en photoluminescence.

On va maintenant décrire plus précisément un mode de réalisation d'un dispositif selon l'invention.

Le substrat est préparé selon l'enseignement du document FR-A-2 766 620. On utilise une plaquette de silicium, de plan cristallographique de surface (1,0,0), de résistivité comprise entre 14 et 22 Ω.cm, dopée p et de 520 µm d'épaisseur. On utilise aussi une structure SOI comprenant un film mince de silicium, de plan cristallographique de surface (1,0,0), de résistivité comprise entre 14 et 22 Ω.cm, dopé p. La plaquette est mise en contact adhérant avec le film mince de la structure SOI. L'angle de rotation entre la plaquette et le film mince est de 5°. L'angle de tilt relatif est de 0,4°. Après élimination du support de la structure SOI et de la couche d'oxyde, le substrat obtenu est préparé pour la mise en oeuvre de l'invention.

La surface du substrat sur laquelle doit être formée la couche intermédiaire est traitée dans un bain d'HF à 10% selon la technique dite DDC. A propos de cette technique, on peut se référer à l'article "Diluted Dynamic Clean : DDC" de F. TARDIF et al., UCPSS'96, 1996, pages 175 à 178.

Une couche intermédiaire de 1,2 nm d'épaisseur, en oxyde de silicium est alors formée par RTO (température 800°C-10% de O₂ dilué dans N₂).

Des nanostructures de silicium sont ensuite déposées par LPCVD à partir de SiH₄ à 620°C, sous une pression de 35 m Torr (environ 4,66 Pa). L'épaisseur équivalente du dépôt est comprise entre 0,5 et 1 nm. On obtient ainsi un réseau bidimensionnel de nanostructures de 6 nm suivant un réseau de 10 nm x 15 nm.

La figure 5 est un exemple d'application qui reprend le dispositif de la figure 4. Dans cet exemple d'application, les nanostructures 4 se trouvent placées entre des électrodes 5 et 6 déposées sur la couche intermédiaire 3. Un tel dispositif permet d'étudier le transport des électrons d'une nanostructure à une autre.

## Revendications

1. Procédé de réalisation de microstructures ou de nanostructures sur un support, comprenant les étapes suivantes :
a) fourniture d'un substrat (1) comprenant au moins une partie en matériau cristallin, cette partie possédant une surface (2) présentant un champ de contrainte ou une topologie associée à un champ de contrainte, la surface (2) étant adaptée à la formation d'une couche de matériau dite couche intermédiaire, par mise en contact de deux plaquettes de matériau cristallin de façon que les réseaux cristallins présentés par les faces des plaquettes mises en contact soient décalés d'un angle permettant la formation d'un réseau de défauts cristallins au sein d'une zone cristalline au voisinage de l'interface des deux plaquettes, l'une des plaquettes étant ensuite amincie jusqu'à révéler ladite surface présentant un champ de contrainte ou une topologie associée à un champ de contrainte, le champ de contrainte étant alors associé à des dislocations, dudit réseau de défauts cristallins,
b) formation de la couche intermédiaire (3) à partir de ladite surface (2),
c) dépôt auto-organisé des microstructures ou des nanostructures (4) sur la face libre de la couche intermédiaire (3),
**caractérisé en ce que**, à l'étape b), l'épaisseur et/ou la composition et/ou l'état de surface de la couche intermédiaire (3) sont choisis pour que le champ de contrainte puisse se transmettre à travers cette couche jusqu'à sa face libre qui est apte à la réalisation de microstructures ou de nanostructures, le substrat (1) et la couche intermédiaire (3) constituant ledit support.

2. Procédé selon la revendication 1, **caractérisé en ce que** l'étape a) comprend un traitement de surface pour adapter ladite surface (2) à la formation d'une couche intermédiaire.

3. Procédé selon la revendication 1, **caractérisé en ce que** la couche intermédiaire (3) est une couche déposée sur ladite surface par une technique PVD et/ou une technique CVD.

4. Procédé selon la revendication 1, **caractérisé en ce que** la couche intermédiaire (3) est obtenue par le dépôt préliminaire d'un matériau sur ladite surface (2), ce dépôt préliminaire étant suivi d'un traitement permettent d'obtenir la composition choisie pour la couche intermédiaire.

5. Procédé selon la revendication 1, **caractérisé en ce que** la couche intermédiaire (3) est obtenue par un traitement transformant une couche du substrat sous-jacente à ladite surface (2) en la composition choisie pour la couche intermédiaire.

6. Procédé selon la revendication 1, **caractérisé en ce que** la couche intermédiaire (3) est obtenue en faisant réagir une couche du substrat sous-jacente à ladite surface avec un matériau déposé sur ladite surface pour obtenir ladite composition choisie.

7. Procédé selon la revendication 1, **caractérisé en ce que** la couche intermédiaire est constituée d'un empilement de sous-couches.

8. Procédé selon la revendication 7, **caractérisé en ce que** les sous-couches sont constituées d'un même matériau mais présentent des rugosités différentes.

9. Procédé selon la revendication 7, **caractérisé en ce que** les sous-couches sont constituées de différents matériaux.

10. Procédé selon la revendication 9, **caractérisé en ce que** les différents matériaux des sous-couches sont choisis parmi SiO₂ et Si₃N₄.

11. Procédé selon la revendication 7, **caractérisé en ce que** l'empilement de sous-couches comprend des sous-couches présentant des valeurs de contrainte de signes opposés.

12. Procédé selon la revendication 1, **caractérisé en ce que** la couche intermédiaire est formée pour présenter un état de contrainte favorisant le dépôt auto-organisé des microstructures ou des nanostructures.

13. Procédé selon la revendication 12, **caractérisé en ce que** la couche intermédiaire est formée de façon à présenter une différence de coefficient de dilatation thermique avec le substrat telle que la couche intermédiaire présente ledit état de contrainte.

14. Procédé selon la revendication 12, **caractérisé en ce que** la couche intermédiaire est formée en faisant varier ses paramètres de croissance de façon à présenter ledit état de contrainte.

15. Procédé selon la revendication 12, **caractérisé en ce que** la couche intermédiaire est formée de façon à présenter une différence de paramètre de maille avec le substrat telle que la couche intermédiaire présente ledit état de contrainte.

16. procédé selon la revendication 1, **caractérisé en ce que** le dépôt auto-organisé des microstructures ou des nanostructures (4) est réalisé par une technique choisie parmi le dépôt PVD, le dépôt CVD, le dépôt LPCVD, l'épitaxie liquide, le trempage, l'épitaxie gazeuse et le dépôt plasma.

17. Procédé selon la revendication 1, **caractérisé en ce que** l'étape de dépôt auto-organisé comporte une superposition de dépôts, un premier dépôt étant effectué sur la face libre de la couche intermédiaire et au moins un deuxième dépôt étant effectue ensuite pour obtenir une organisation tridimensionnelle des microstructures ou des nanostructures.

18. Procédé selon la revendication 1, **caractérisé en ce que** la face libre de la couche intermédiaire est traitée pour lui conférer un relief tel que les microstructures ou les nanostructures sont déposées selon une organisation tridimensionnelle.

19. Dispositif constitué de microstructures ou de nanostructures sur un support, comprenant :
- un substrat (1) comprenant au moins une partie en matériau cristallin, cette partie possédant une surface (2) présentant un champ de contrainte ou une topologie associée à un champ de contrainte, le substrat étant constitué d'une plaquette de matériau cristallin adhérant à un film mince de matériau cristallin selon des faces de contact, les réseaux cristallins présentés par les faces en contact étant décalés d'un angle permettant la formation d'un réseau de défauts cristallins au sein d'une zone cristalline au voisinage de l'interface entre la plaquette et le film mince, le champ de contrainte étant alors associé à des dislocations dudit réseau de défauts cristallins,
- une couche intermédiaire (3) solidaire de ladite surface (2),
**caractérisé en ce que** la couche intermédiaire possède une épaisseur et/ou une composition et/ou un état de surface permettent la transmission dudit champ de contrainte à travers cette couche jusqu'à sa face libre qui supporte les microstructures ou les nanostructures (4).

20. Dispositif selon la revendication 19, **caractérisé en ce que** la couche intermédiaire est constituée d'un empilement de sous-couches.

21. Dispositif selon la revendication 19, **caractérisé en ce que** la couche intermédiaire est une couche présentant un état de contrainte favorisant le dépôt auto-organisé des microstructures ou de nanostructures.

22. Dispositif selon la revendication 21, **caractérisé en ce que** la couche intermédiaire présente une différence de coefficient de dilatation thermique avec le substrat telle que la couche intermédiaire présente ledit état de contrainte.

23. Dispositif selon la revendication 20, **caractérisé en ce que** les microstructures ou les nanostructures sont disposées selon des couches superposées, formant ainsi une organisation tridimensionnelle.

24. Dispositif selon la revendication 20, **caractérisé en ce que** la couche intermédiaire possède une face libre présentant un relief tel que les microstructures ou les nanostructures forment une organisation tridimensionnelle.

## Claims

1. A method for making microstructures or nanostructures on a support, comprising the following steps:
a) provision of a substrate (1) comprising at least one portion in crystalline material, this portion possessing a surface (2) having a stress field or a topology associated with a stress field, the surface (2) being adapted to the formation of a material layer, a so-called intermediate layer, by putting two crystalline material wafers into contact with each other so that the crystalline lattices shown by the faces of the wafers put into contact with each other are shifted by an angle allowing the formation of a lattice of crystalline defects within a crystalline area in the vicinity of the interface of both wafers, one of the wafers then being thinned until said surface having a stress field or a topology associated with a stress field is revealed, the stress field then being associated with dislocations, of said lattice of crystalline defects,
b) formation of the intermediate layer (3) from said surface (2),
c) self-organized deposition of the microstructures or nanostructures (4) on the free face of the intermediate layer (3),
**characterized in that**, in step b), the thickness and/or the composition and/or the surface condition of the intermediate layer (3) are selected so that the stress field may be transmitted through this layer as far as its free face which is suitable for the making of microstructures or nanostructures, the substrate (1) and the intermediate layer (3) forming said support.

2. The method according to claim 1, **characterized in that** the step a) comprises a surface treatment for adapting said surface (2) to the formation of an intermediate layer.

3. The method according to claim 1, **characterized in that** the intermediate layer (3) is a layer deposited on said surface by a PVD technique and/or a CVD technique.

4. The method according to claim 1, **characterized in that** the intermediate layer (3) is obtained by preliminary deposition of a material on said surface (2), this preliminary deposition being followed by a treatment with which the composition selected for the intermediate layer may be obtained.

5. The method according to claim 1, **characterized in that** the intermediate layer (3) is obtained by a treatment transforming a layer of the substrate, underlying said surface (2), into the composition selected for the intermediate layer.

6. The method according to claim 1, **characterized in that** the intermediate layer (3) is obtained by reacting a layer of the substrate, underlying said surface, with a material deposited on said surface in order to obtain said selected composition.

7. The method according to claim 1, **characterized in that** the intermediate layer consists of a stack of sub-layers.

8. The method according to claim 7, **characterized in that** the sub-layers consist of a same material but having different roughnesses.

9. The method according to claim 7, **characterized in that** the sub-layers consist of different materials.

10. The method according to claim 9, **characterized in that** the different materials of the sub-layers are selected from SiO₂ and Si₃N₄.

11. The method according to claim 7, **characterized in that** the stack of sub-layers comprises sub-layers having stress values of opposite signs.

12. The method according to claim 1, **characterized in that** the intermediate layer is formed in order to have a stress condition promoting self-organized deposition of microstructures or nanostructures.

13. The method according to claim 12, **characterized in that** the intermediate layer is formed so as to have a heat expansion coefficient difference with the substrate such that the intermediate layer has said stress condition.

14. The method according to claim 12, **characterized in that** the intermediate layer is formed by varying its growth parameters so as to have said stress condition.

15. The method according to claim 12, **characterized in that** the intermediate layer is formed so as to have a lattice parameter difference with the substrate such that the intermediate layer has said stress condition.

16. The method according to claim 1, **characterized in that** the self-organized deposition of microstructures or nanostructures (4) is achieved by a technique selected from PVD deposition, CVD deposition, LPCVD deposition, liquid epitaxy, soaking, gas epitaxy and plasma deposition.

17. The method according to claim 1, **characterized in that** the self-arganized deposition step includes a superposition of depositions, a first deposition being carried out on the free face of the intermediate layer and at least one second deposition being then carried out in order to obtain a three-dimensional organization of microstructures or nanostructures.

18. The method according to claim 1, **characterized in that** the free face of the intermediate layer is treated so as to provide it with a relief such that the microstructures or nanostructures are deposited according to a three-dimensional organization.

19. A device consisting of microstructures or nanostructures on a support, comprising:
- a substrate (1) comprising at least one portion in crystalline material, this portion possessing a surface (2) having a stress field or a topology associated with a stress field, the substrate consisting of a crystalline material wafer adhering to a thin film of crystalline material along contact faces, the crystalline lattices shown by the faces in contact being shifted by an angle allowing the formation of a lattice of crystalline defect within a crystalline area in the vicinity of the interface between the wafer and the thin film, the stress field then being associated with dislocations of said lattice of crystalline defects,
- an intermediate layer (3) firmly attached to said surface (2),
**characterized in that** the intermediate layer possesses a thickness and/or a composition and/or a surface condition allowing transmission of said stress field through this layer as far as its free face which supports the microstructures or nanostructures (4).

20. The device according to claim 19, **characterized in that** the intermediate layer consists of a stack of sub-layers.

21. The device according to claim 19, **characterized in that** the intermediate layer is a layer having a stress condition promoting self-organized deposition of the microstructures or nanostructures.

22. The device according to claim 21, **characterized in that** the intermediate layer has a heat expansion coefficient difference with the substrate such that the intermediate layer has said stress condition.

23. The device according to claim 20, **characterized in that** the microstructures or nanostructures are arranged along superposed layers, thereby forming a three-dimensional organization.

24. The device according to claim 20, **characterized in that** the intermediate layer possesses a free face having a relief such that the microstructures or nanostructures form a three-dimensional organization.

## Patentansprüche

1. Verfahren zur Realisierung von Mikrostrukturen oder Nanostrukturen auf einem Träger, umfassend die folgenden Schritte:
a) Bereitstellen eines Substrats (1), umfassend wenigstens einen Teil aus einem kristallinen Material, wobei dieser Teil eine Oberfläche (2) besitzt, die ein Spannungsfeld oder eine mit einem Spannungsfeld verbundene Topologie aufweist, wobei die Oberfläche (2) angepasst ist an die Bildung einer als Zwischenschicht bezeichneten Materialschicht, durch In-Kontakt-Bringen von zwei Scheiben aus kristallinem Material, so dass die Kristallgitter, die von den in Kontakt gebrachten Seiten der Scheiben gezeigt werden, um einen Winkel versetzt sind, was die Bildung eines Gitters mit Kristalldefekten innerhalb eines kristallinen Bereichs in der Nachbarschaft der Verbindungsstelle der zwei Scheiben ermöglicht, wobei die eine der Scheiben anschließend dünner gemacht wird, bis die Oberfläche freigelegt ist, die ein Spannungsfeld oder eine mit einem Spannungsfeld verbundene Topologie aufweist, wobei das Spannungsfeld nun mit Versetzungen des Gitters mit Kristalldefekten verbunden ist,
b) Bilden der Zwischenschicht (3) ausgehend von der Oberfläche (2),
c) selbstorganisiertes Aufbringen von Mikrostrukturen oder Nanostrukturen (4) auf der freien Seite der Zwischenschicht (3), **dadurch gekennzeichnet, dass** in Schritt b) die Dicke oder/und die Zusammensetzung oder/und der Zustand der Oberfläche der Zwischenschicht (3) ausgewählt wird/werden, damit das Spannungsfeld sich über diese Schicht hinweg bis zu ihrer freien Seite übertragen kann, die geeignet ist für die Realisierung von Mikrostrukturen oder Nanostrukturen, wobei das Substrat (1) und die Zwischenschicht (3) den Träger bilden.

2. Verfahren nach Anspruch 1,
dadurch gekenntzeichnet, dass der Schritt a) eine Oberflächenbehandlung umfasst, um die Oberfläche (2) an die Bildung einer Zwischenschicht anzupassen.

3. Verfahren nach Anspruch 1,
**dadurch gekennzeichnet, dass** die Zwischenschicht (3) eine Schicht ist, die auf der Oberfläche durch eine PVD-Technik oder eine CVD-Technik aufgebracht worden ist.

4. Verfahren nach Anspruch 1,
**dadurch gekennzeichnet, dass** die Zwischenschicht (3) durch das vorherige Aufbringen eines Materials auf die Oberfläche (2) erhalten wird, wobei dem vorherigen Aufbringen eine Behandlung folgt, die es ermöglicht, die gewählte Zusammensetzung für die Zwischenschicht zu erhalten.

5. Verfahren nach Anspruch 1,
**dadurch gekennzeichnet, dass** die Zwischenschicht (3) durch eine Behandlung erhalten wird, die eine unter der Oberfläche (2) liegende Schicht des Substrats in die für die Zwischenschicht gewählte Zusammensetzung umwandelt.

6. Verfahren nach Anspruch 1,
**dadurch gekennzeichnet, dass** die Zwischenschicht (3) erhalten wird, indem man eine unter der Oberfläche liegende Schicht des Substrats mit einem auf die Oberfläche aufgebrachten Material reagieren lässt, um die gewählte Zusammensetzung zu erhalten.

7. Verfahren nach Anspruch 1,
**dadurch gekennzeichnet, dass** die Zwischenschicht aus einem Stapel von Unter-Schichten besteht.

8. Verfahren nach Anspruch 7,
**dadurch gekennzeichnet, dass** die Unter-Schichten aus dem gleichen Material bestehen, aber unterschiedliche Rauigkeiten aufweisen.

9. Verfahren nach Anspruch 7,
**dadurch gekennzeichnet, dass** die Unter-Schichten aus unterschiedlichen Materialien bestehen.

10. Verfahren nach Anspruch 9,
**dadurch gekennzeichnet, dass** die unterschiedlichen Materialien der Unter-Schichten ausgewählt sind aus SiO₂ und Si₃N₄.

11. Verfahren nach Anspruch 7,
**dadurch gekennzeichnet, dass** der Stapel von Unter-Schichten Unter-Schichten umfasst, die Spannungswerte mit entgegengesetzten Vorzeichen aufweisen.

12. Verfahren nach Anspruch 1,
**dadurch gekennzeichnet, dass** die Zwischenschicht gebildet ist, um einen Spannungszustand aufzuweisen, der das selbstorganisierte Aufbringen der Mikrostrukturen oder der Nanostrukturen begünstigt.

13. Verfahren nach Anspruch 12,
**dadurch gekennzeichnet, dass** die Zwischenschicht so gebildet ist, dass sie einen Unterschied im Wärmeausdehnungskoeffizienten zum Substrat aufweist, so dass die Zwischenschicht den Spannungszustand aufweist.

14. Verfahren nach Anspruch 12,
**dadurch gekennzeichnet, dass** die Zwischenschicht gebildet wird, indem man ihre Wachstumsparameter so variieren lässt, dass sie den Spannungszustand aufweist.

15. Verfahren nach Anspruch 12,
**dadurch gekennzeichnet, dass** die Zwischenschicht so gebildet wird, dass sie einen Unterschied im Gitterparameter zum Substrat aufweist, so dass die Zwischenschicht den Spannungszustand aufweist.

16. Verfahren nach Anspruch 1,
**dadurch gekennzeichnet, dass** das selbstorganisierte Aufbringen der Mikrostrukturen oder der Nanostrukturen (4) durch eine Technik realisiert wird, die ausgewählt ist aus der PVD-Beschichtung, der CVD-Beschichtung, der LPCVD-Beschichtung, der Flüssigepitaxie, dem Eintauchen, der Gas-Epitaxie und der Plasma-Beschichtung.

17. Verfahren nach Anspruch 1,
**dadurch gekennzeichnet, dass** der Schritt des selbstorganisierten Aufbringens eine Überlagerung von Depositions-Schritten umfasst, wobei eine erste Deposition auf der freien Seite der Zwischenschicht durchgeführt wird und wenigstens eine zweite Deposition anschließen durchgeführt wird, um eine dreidimensionale Organisation von Mikrostrukturen oder Nanostrukturen zu erhalten.

18. Verfahren nach Anspruch 1,
**dadurch gekennzeichnet, dass** die freie Seite der Zwischenschicht behandelt wird, um ein Relief darauf zu übertragen, so dass die Mikrostrukturen oder die Nanostrukturen gemäß einer dreidimensionalen Organisation aufgebracht werden.

19. Vorrichtung, gebildet aus Mikrostrukturen oder Nanostrukturen auf einem Träger, umfassend:
- ein Substrat (1), das wenigstens einen Teil aus einem kristallinen Material umfasst, wobei dieser Teil eine Oberfläche (2) besitzt, die ein Spannungsfeld aufweist oder eine Topologie, die mit einem Spannungsfeld verbunden ist, wobei das Substrat aus einer Scheibe aus einem kristallinen Material gebildet ist, die entlang von Kontaktflächen an einem dünnen Film aus einem kristallinen Material haftet, wobei die Kristallgitter, die von den Kontaktflächen gezeigt werden, um einen Winkel versetzt sind, was die Bildung eines Gitters mit Kristalldefekten innerhalb eines kristallinen Bereichs in der Nachbarschaft der Verbindungsstelle zwischen der Scheibe und dem dünnen Film ermöglicht, wobei das Spannungsfeld nun mit Versetzungen des Gitters mit Kristalldefekten verbunden ist,
- eine fest mit der Oberfläche (2) verbundene Zwischenschicht (3), dadurch gekenntzeichnet, dass die Zwischenschicht eine Dicke oder/und eine Zusammensetzung oder/und einen Oberflächenzustand besitzt, der/die die Übertragung des Spannungsfelds über diese Schicht hinweg bis zu ihrer freien Seite ermöglicht/ermöglichen, welche die Mikrostrukturen oder die Nanostrukturen (4) trägt.

20. Vorrichtung nach Anspruch 19,
**dadurch gekennzeichnet, dass** die Zwischenschicht aus einem Stapel von Unter-Schichten gebildet ist.

21. Vorrichtung nach Anspruch 19,
**dadurch gekennzeichnet, dass** die Zwischenschicht eine Schicht ist, die einen Spannungszustand aufweist, welcher das selbstarganisierte Aufbringen der Mikrostrukturen oder der Nanostrukturen begünstigt.

22. Vorrichtung nach Anspruch 21,
**dadurch gekennzeichnet, dass** die Zwischenschicht einen Unterschied im Wärmeausdehnungskoeffizienten zu dem Substrat aufweist, so dass die Zwischenschicht den Spannungszustand aufweist.

23. Vorrichtung nach Anspruch 20,
**dadurch gekennzeichnet, dass** die Mikrostrukturen oder die Nanostrukturen gemäß überlagerter Schichten aufgebracht sind und so eine dreidimensionale Organisation bilden.

24. Vorrichtung nach Anspruch 20,
**dadurch gekennzeichnet, dass** die Zwischenschicht eine freie Seite besitzt, die ein Relief aufweist, so dass die Mikrostrukturen oder die Nanostrukturen eine dreidimensionale Organisation bilden.
